# EUROPEAN PATENT SPECIFICATION

(11) **EP 3 909 405 B1**
(45) Date of publication and mention of the grant of the patent: **22.05.2024**
(21) Application number: 19712896.0
(22) Date of filing: 12.02.2019
(51) Int. Cl.: H05K 7/20, H01L 23/367

(54) **A HEAT SINK FOR A REMOTE RADIO UNIT**
KÜHLKÖRPER FÜR EINE ENTFERNTE FUNKEINHEIT
DISSIPATEUR THERMIQUE POUR UNE UNITÉ RADIO DISTANTE

(43) Date of publication of application: 17.11.2021
(73) Proprietor: HUAWEI TECHNOLOGIES CO., LTD., Shenzhen, Guangdong 518129, P.R. (CN)
(72) Inventor: ZAKHAREVICH, Aliaksei, Shenzhen, Guangdong 518129, P. R. (CN); TANG, Yun, Shenzhen, Guangdong 518129, P. R. (CN); SHIRKO, Aleksey, Shenzhen, Guangdong 518129, P. R. (CN)
(74) Representative: Gill Jennings & Every LLP
(86) International application number: PCT/BY2019/000001
(87) International publication number: WO 2020/163936

(56) References cited:
- WO-A1-2014/026474
- CN-A- 104 734 408
- JP-A- 2017 190 897
- US-A1- 2016 183 398
- US-B2- 8 811 439

## Description

### TECHNICAL FIELD

The present invention relates generally to the field of heat sinks, particularly natural convection cooling (NCC) heat sinks. The present invention proposes a heat sink for a remote radio unit (RRU). However, the proposed heat sink can also be applied to another device of a wireless network. The invention also proposes a heat sink blade including at least one proposed heat sink, and proposes a fabrication method of the proposed heat sink.

### BACKGROUND

A RRU in a wireless network is a remote radio transceiver, which connects to an operator radio control panel via an electrical or wireless interface. The RRU generates heat, and it is expected that the RRU heat load will continue to increase at least over the next years. Thus, it is generally desired and required to develop new heat sinks, particularly more effective heat sinks, particularly NCC heat sinks.

From a thermal point of view, the most challenging installation scenario of such heat sinks in a wireless network is a heat sink blade installation scenario. In this scenario, multiple (e.g., three) RRUs (each RRU being provided with a heat sink) are installed close to each other. The cooling air flow between heat sinks of such a heat sink blade is critical. The worst conditions for heat dissipation are typically observed for a heat sink of a RRU located between (in the middle of) heat sinks.

Additionally, cost reductions of NCC heat sinks for mass-production are also desired.

A particular NCC heat sink is presented in CN 206118266 U. This heat sink (referred to below as the "conventional" heat sink) comprises main fins with specially arranged secondary fins (called extension surfaces).

Another, exemplary heat sink (referred to in the following as "reference heat sink") consists of main plate-fins with attached secondary fins. Secondary finning (i.e. secondary fins) of an upper part of the heat sink is made of a solid plate. Secondary finning of a lower part of the heat sink is made of separated horizontal strips. For high-volume manufacturing, both the upper and lower parts of the secondary finning are combined into one plate, which is manufactured by stamping the sheet metal.

This heat sink design, however, is rather expensive to manufacture. Furthermore, the thermal performance of this heat sink design is not satisfactory, in particular in the above-mentioned blade installation scenario.

US 8 811 439 B2 discloses a semiconductor laser assembly and packaging system, comprising a heat sink with T-shaped and flat fins.

JP 2017 190897 A discloses an air blowing device, comprising a heat sink with T-shaped and flat fins.

CN 104 734 408 A discloses an explosion-proof motor shell, comprising a heat sink with T-shaped and flat fins.

WO 2014/026474 A1 discloses a radio remote unit device and assembly thereof, comprising a conventional heat sink with flat fins.

### SUMMARY

The present invention aims to provide an efficient heat sink and heat sink blade. An objective is in particular to provide a heat sink that has a high thermal performance, particularly in the above-mentioned blade installation scenario. Further, the heat sink should have reduced manufacturing costs.

The objective is achieved by the embodiments of the invention as described in the enclosed independent claims. Advantageous implementations of the present invention are further defined in the dependent claims.

The embodiments of the invention are based on the understanding why the conventional heat sink with fins of T-shaped cross-section presented in CN 206118266 U (see FIG. 2 of CN 206118266 U) has no satisfactory thermal performance both in single installation and above-mentioned blade installation scenario. That is, in this heat sink design, a gap between secondary fins is located in the middle of an air channel between main fins. This leads to a reduced cooling efficiency of the air that enters the heat sink between the secondary fins, since there is no direct contact of the (fresh) air with the hot surface of the main fins.

Embodiments of the invention thus provide a heat sink with an improved thermal performance, by using secondary fins (finning) not only to extend heat transfer surfaces of primary fins (main fins), but also to guide cooling air flowing through the secondary finning into the heat sink directly onto hot surfaces of the main fins not covered by strips (plates) of secondary finning.

A first aspect of the invention provides a heat sink for a remote radio unit, the heat sink comprising: a base, at least three primary fins arranged in a row, wherein each primary fin extends from the base and comprises two lateral faces which face into two opposite lateral directions, and at least two secondary fins formed on the primary fins, wherein each secondary fin extends from one of the primary fins into the two opposite lateral directions associated with that primary fin, wherein only every second primary fin in the row of primary fins is provided with a secondary fin and wherein the heat sink comprises an integral metal plate which comprises the plurality of the secondary fins.

In this patent application, a "fin" is a generally a flat or plate-shaped body attached to or forming part of a bigger body. Each primary fin in the heat sink of the first aspect may be a plate, i.e. a flat body, with two main faces, which are the above-mentioned two lateral faces.

In an embodiment, the base of the heat sink comprises a rectangular surface having a long edge and a short edge, wherein each primary fin extends parallel to the long edge of the rectangular surface. However, in general, the base can be flat or curved. The primary fins may be attached perpendicular to the base, and may be oriented along the gravity vector. The secondary fins may also be oriented along the gravity vector. The primary and secondary fins may be mutually perpendicular.

Compared to the conventional heat sink design presented in CN 206118266 U (shown in FIG. 2 of CN 206118266 U), a gap between the secondary fins is moved from the middle part of the air channel between main fins to the side of the channel in the heat sink of the first aspect. This is achieved by providing only every second primary fin in the row of primary fins with a secondary fin. As a consequence, the thermal performance of the heat sink of the first aspect is significantly higher than that of the conventional heat sink. Also compared to the reference heat sink, the thermal performance of the heat sink of the first aspect is considerably improved, particularly in the blade installation scenario. Further, compared to the conventional heat sink design presented in CN 206118266 U, the base of the heat sink of the first aspect can be manufactured together with the main fins, which leads to considerably lower costs, and a higher thermal performance because of zero contact thermal resistance between the base and the main fins. Compared to the conventional design with fins of L-shaped cross-section (shown in FIG. 1 of CN 206118266 U), fabrication of the main fins together with the base is followed by a less complicated and costly connection of the secondary fins to the main fins in the heat sink of the first aspect. Further, compared to the conventional heat sink with fins of T-shaped cross-section (shown in FIG. 2 of CN 206118266 U), a thermal performance of the heat sink of the first aspect is improved both in a single installation and the above-mentioned blade installation scenario.

In an implementation form of the first aspect, each primary fin comprises a plate which is arranged on the base and oriented perpendicularly to the base, and each secondary fin comprises a plate arranged on a primary fin and oriented parallel to the base.

A cross-section of a combination of a primary fin and a secondary fin may thus have a T-shape.

In an implementation form of the first aspect, a space is formed between neighboring secondary fins provided on primary fins in the row of primary fins, and a primary fin is arranged, particularly centered, in the space. This allows guiding cool air into the heat sink in an optimized manner.

In this way, the secondary fins do not only extend the heat transfer surface of the primary fins, which they are attached to, but they also guide cooling air into the heat sink, particularly directly onto a hot surface of the main fin arranged in the gap. Thus, the thermal performance of the heat sink is improved.

In an implementation form of the first aspect, a gap is formed between an edge of a secondary fin provided on a primary fin and a top edge of a neighboring primary fin in the row of primary fins.

Thus, that secondary fin is adapted to guide air onto the hot surface of the neighboring primary fin.

This makes the heat sink device particularly easy and cheap to manufacture, especially the secondary finning of the heat sink.

In an implementation form of the first aspect, the space between two neighboring secondary fins is formed by an opening in the integral metal plate.

In this way, multiple strips of secondary fins can be combined into one integral metal plate, in order to improve the mechanical strength of the secondary fins, and reduce manufacturing costs.

In an implementation form of the first aspect, the opening in the integral metal plate is elongated and extends over and along the top edge of a primary fin.

In an implementation form of the first aspect, the integral metal plate comprises one or more further elongated openings extending perpendicularly to the elongated opening that extends over and along the top edge of the primary fin.

In an implementation form of the first aspect, the integral metal plate has been formed by stamping a metal sheet.

This enables a particularly easy and cheap manufacturing process of the heat sink of the first aspect.

In an implementation form of the first aspect, the integral metal plate comprises a plurality of sections, each section forming a plurality of secondary fins arranged in a row.

Thus, different variations/designs of the heat sink of the first aspect can be easily and flexibly fabricated.

A second aspect of the invention provides a heat sink blade comprising at least two stacked heat sinks, wherein at least one of the heat sinks is a heat sink according to the first aspect or any of its implementation forms.

Due to the heat sink of the first aspect, the thermal performance of the heat sink blade is significantly improved. If the heat sink blade includes three stacked heat sinks, preferably the middle heat sink is realized by the heat sink of the first aspect.

A third aspect of the invention provides a method for fabricating a heat sink, the method comprising: forming a base and at least three primary fins as a single piece, wherein each primary fin extends from the base and comprises two lateral faces which face into two opposite lateral directions, and forming at least two secondary fins on the primary fins by attaching, for each secondary fin, a plate to a primary fin such that the plate extends from one of the primary fins into the two opposite lateral directions associated with that primary fin, wherein only every second primary fin in the row of primary fins is provided with a secondary fin.

The base and the primary fins may be formed together by die-casting, for example. In an embodiment, for each secondary fin, the plate is attached to a top edge or top face of the respective primary fin.

In an implementation form of the third aspect, the method comprises: providing a metal sheet, stamping the metal sheet to produce an integral metal plate with at least one elongated opening, and attaching the integral metal plate to the primary fins, wherein each elongated opening extends over and along the top edge of a primary fin.

The fabrication method of the third aspect and its implementation forms achieve the advantages and effects of the heat sink of the first aspect and its implementations forms.

It has to be noted that all devices, elements, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

### BRIEF DESCRIPTION OF THE DRAWINGS

The above described aspects and implementation forms of the present invention will be explained in the following description of specific embodiments in relation to the enclosed drawings, in which:
- FIG. 1: shows a heat sink according to an embodiment not covered by the claimed invention.
- FIG. 2: shows a heat sink according to an embodiment not covered by the claimed invention.
- FIG. 3: shows a heat sink according to an embodiment of the invention.
- FIG. 4: shows a heat sink according to an embodiment of the invention.
- FIG. 5: shows a heat sink blade according to an embodiment of the invention.
- FIG. 6: illustrates advantages of embodiments of the invention.
- FIG. 7: shows a method according to an embodiment not covered by the claimed invention.

### DETAILED DESCRIPTION OF EMBODIMENTS

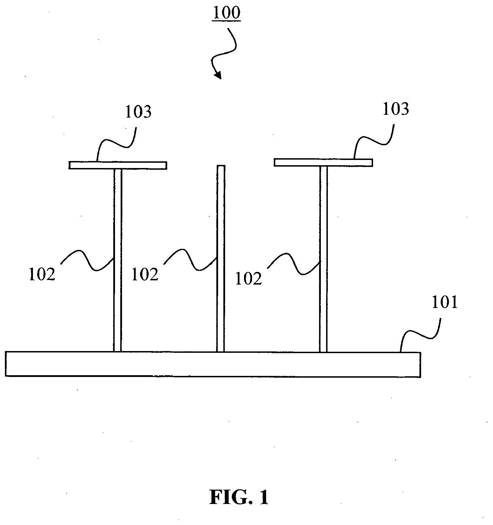

FIG. 1 shows a heat sink 100 according to an embodiment not covered by the claimed invention, since the secondary fins 103 are not limited to being part of an integral metal plate 300, as required by the independent claims. The heat sink 100 is particularly suitable for being applied to a RRU, but it may also be applied e.g., to any other device in a wireless network that generates heat and needs cooling. The heat sink 100 shown in FIG. 1 is based on a technique of using primary fins and secondary finning to increase the heat transfer surface of the primary fins.

The heat sink 100 comprises a base 101, which may be a metal sheet or block or the like. The heat sink 100 further includes at least three primary fins 102 arranged in a row, wherein each primary fin 102 extends from the base 101 and comprises two lateral faces which face into two opposite lateral directions. For instance, as exemplarily shown in FIG. 1, each primary fin 102 may comprise a plate, which is arranged on the base 101 and is oriented perpendicularly to the base 101. The heat sink 100 may also include more than one row of primary fins 102, i.e. a plurality of rows each including multiple primary fins 102. Further, the heat sink 100 also includes at least two secondary fins 103 formed on the primary fins 102, wherein each secondary fin 103 extends from one of the primary fins 102 into the two opposite lateral directions associated with that primary fin 102. For instance, as exemplarily shown in FIG. 1, each secondary fin 103 comprises a plate arranged on a primary fin 102 and oriented parallel to the base 101. Thus, in the cross-section shown in FIG. 1, the primary fins 102 provided with secondary fins 103 have a T-shape.

In the heat sink 100 of FIG. 1, in order to improve the thermal performance of the heat sink 100, only every second primary fin 102 in a row of primary fins 102 is provided with a secondary fin 103. If the heat sink 100 includes more than one row of primary fins 102, only every second primary fin 102 in each row of primary fins 102 is provided with a secondary fin 103. The secondary fins 103 may thereby all be identical, and arranged identically on the primary fins 103, but may also differ from each other, e.g., in length or orientation on the primary fin 103.

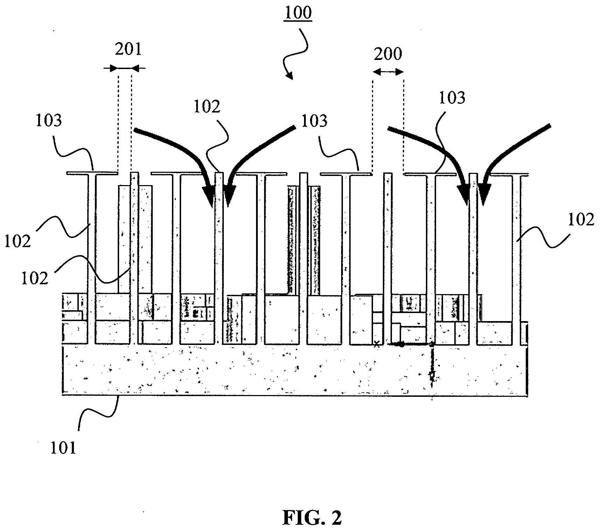

FIG. 2 shows a heat sink 100 according to an embodiment not covered by the claimed invention, since the secondary fins 103 are not limited to being part of an integral metal plate 300, as required by the independent claims, which builds on the heat sink 100 shown in FIG. 1. Same elements are labelled with the same reference signs and function likewise. Thus, the heat sink 100 of FIG. 2 also includes base 101, primary fins 102, and secondary fins 103.

FIG. 2 shows further that a space 200 is formed between neighboring secondary fins 103, i.e. between secondary fins 102 provided on neighboring primary fins 102 in the row of primary fins 102. Thus, in a heat sink 100 with more than three primary fins 102, multiple spaces 200 are formed (as illustrated). Thereby, a primary fin 102 is arranged in each formed space 200. Particularly, the primary fin 102 may be centered in the space 200.

This means that also a gap 201 is formed between an edge of a secondary fin 103 provided on a primary fin 102 and a top edge of a neighboring primary fin 102 (in the row of primary fins 102), i.e. a primary fin 102 arranged in a space 200 between two secondary fins 103. As indicated by the arrows in FIG. 2, this leads to a guiding of air flow into the heat sink 100, particularly onto the two opposite lateral (hot) surfaces of the primary fin 102, which is arranged (e.g., centered) in the space 200. Accordingly, the thermal performance of the heat sink 100 is improved.

In other words, a main technical element of the heat sink 100 is the special arrangement of the secondary fins 103, which are attached to the tips of the main fins 102. The arrangement helps to improve the thermal heat sink performance by guiding the cooling air flowing through the secondary fins 103 into the heat sink 100 directly onto hot surfaces of main fins 102, which are not covered by secondary fins 103.

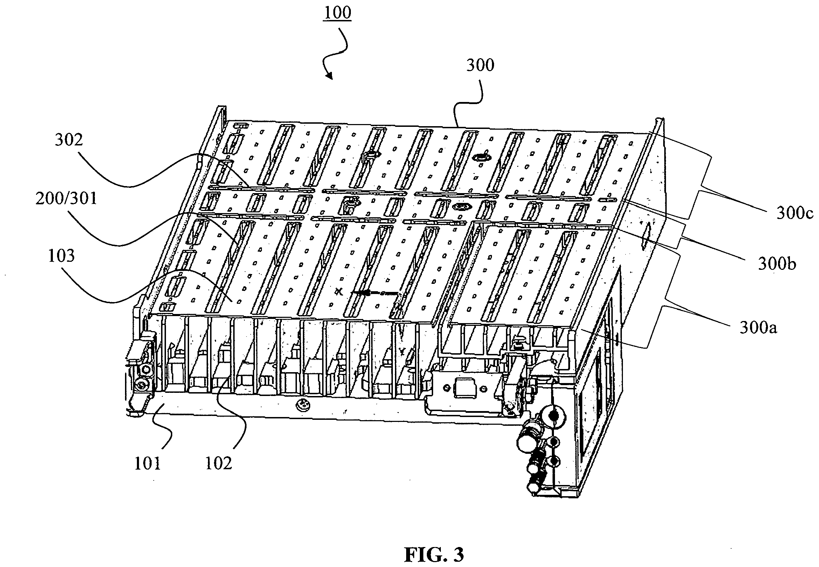

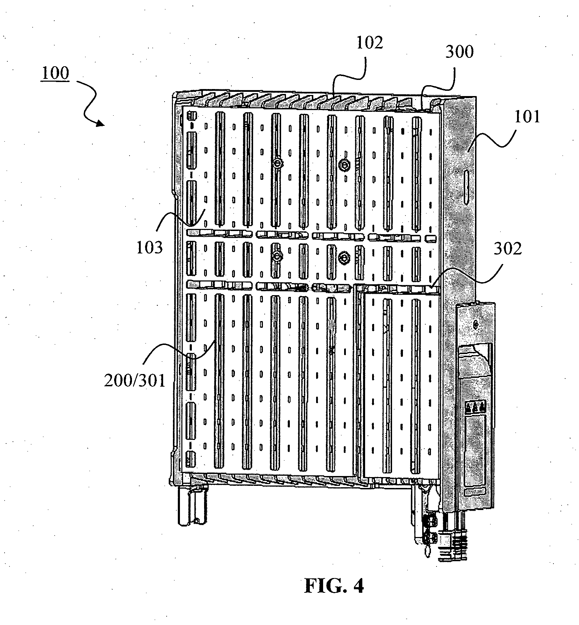

FIG. 3 and 4 shows a heat sink 100 according to an embodiment of the invention, which builds on the heat sink 100 shown in FIG. 1. Same elements are labelled with the same reference signs and function likewise. Thus, the heat sink 100 of FIG. 3 and 4 also includes the base 101, the at least three primary fins 102, and the at least one secondary fin 103.

FIG. 3 and 4 show that the heat sink 100 can comprise an integral metal plate 300, which comprises a plurality of the secondary fins 103. The plate 300 may be formed by stamping a metal sheet. Further, the base 101 of the heat sink 100 may be fabricated by using a die-casting process, particularly together with the primary fins 102. Then, the metal plate 300 of the secondary fins may be fabricated by stamping the sheet metal, and by attaching the plate 300 to the die-casted part of the heat sink 100. In this way, the heat sink 100 can be manufactured in a very low complex and low cost manner.

As shown in FIG. 3 and 4, the above-described space 200 between two neighboring secondary fins 103, which guides the cooling air into the heat sink 100, may be formed by an opening 301 (e.g., stamped) in the integral metal plate 300. In particular, the opening 301 may be elongated as shown, and thus may extend over and along the top edge of a primary fin 102. In this may, this primary fin 102 is arranged, particularly centered, in the elongated space 200/301.

The plate 300 may comprise further elongated openings 302, as shown in FIGs. 3 and 4, in order to further improve the thermal performance of the heat sink 100, in particular when used in a blade installation scenario. The further openings 302 may e.g., extend perpendicular to the elongated openings 301 extending over and along the top edge of the primary fins 102. The integral metal plate 300 may also be divided into a plurality of sections 300a, 300b, 300c, for instance by the further openings 302, wherein each section may form a plurality of secondary fins 103 arranged in a row and provided to a plurality of primary fins 102 also arranged in a row. Thereby, in each row of primary fins 102, a secondary fin 103 is provided on each second primary fin 102.

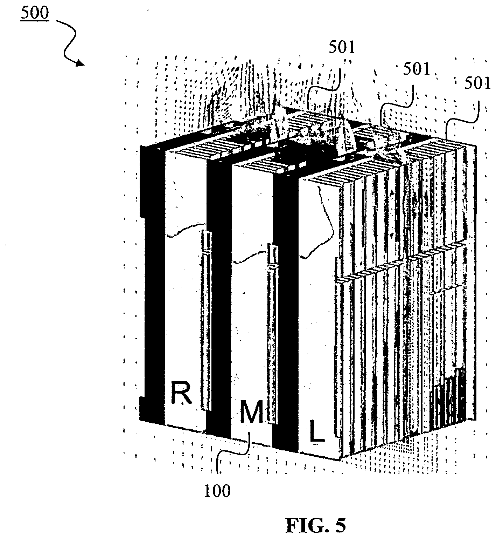

FIG. 5 shows a heat sink blade 500 according to an embodiment of the invention. The heat sink blade 500 comprises at least two stacked heat sinks 501, wherein at least one of the heat sinks 501 is designed according to the heat sink 100 of FIGs. 1-4. In FIG. 5, exemplarily a heat sink blade 500 with three stacked heat sinks 501 is shown. In such a heat sink blade 500, advantageously at least the middle heat sink 501 is designed like the heat sink 100 of FIGs. 1-4. The at least one heat sink 100 provides the heat sink blade 500 with an improved thermal performance, specifically of the most challenging heat sink 501 arranged in the middle (or generally between two other heat sinks 501).

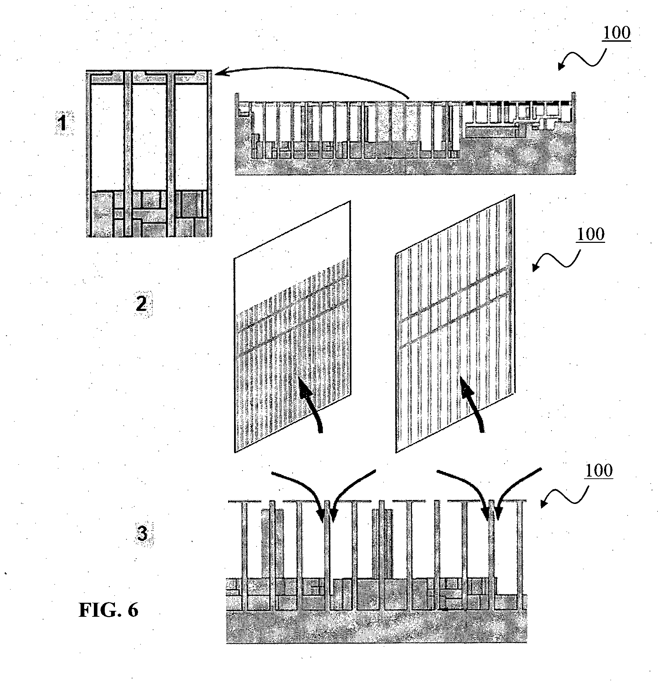

Overall, the heat sink 100 (and consequently also the heat sink blade 500) shown in FIGs. 1-4 has an improved thermal performance and also reduced manufacturing costs, when compared to the heat sink design of CN 206118266 U or when compared to the exemplary reference heat sink described above. The table below describes the advantages of the heat sink 100 with further reference to FIG. 6, where the advantages are illustrated.

| **Advantage** | **Qualitative description** | **Quantitative description** |
|---|---|---|
| **1** | Larger area of passage for air at horizontal cross-section of heat sink. | Area of heat sink bottom inlet is higher by 8%. Airflow in the heat sink outlet is increased by 7%, because of more air comes into the heat sink through the bottom. |
| **2** | Better conditions for absorbing air into heat sink from the space between modules (lower airflow resistance and lower temperature of entering air). | 2.1: Area of the space between secondary fins is lower by 22%. But the same mass-flow enters heat sink through the front. |
| | | 2.2: Temperature of entering air is lower by 7.4°C. |
| **3** | Air flows from space between modules into heat sink right onto usual main fins. Thus providing better contact of fresh air with heat transfer surface. | Heat transfer surface of main fins is the same. but heat sink provides better cooling (higher by 14W or 12% relatively to corresponding value of the reference heat sink. |

FIG. 6 shows in (1) that the heat sink 100 provides a larger area of passage for air at horizontal cross-section of heat sink 100 than in the exemplary reference heat sink design described above. For instance, the area of the heat sink bottom inlet of the heat sink 100 is higher by 8% than of the reference heat sink. The airflow in the heat sink outlet of the heat sink 100 is increased by 7%, because of more air comes into the heat sink 100 through the bottom, compared to the reference heat sink.

FIG. 6 shows in (2) that the heat sink 100 (shown on the right) provides better conditions for absorbing air into the heat sink 100 through the spaces 200 between the secondary fins 103 (indicated by arrows). This is due to a lower airflow resistance and lower temperature of the entering air. For instance, compared to the reference heat sink, the total area of the spaces 200 and 302 between the secondary fins 103 is lower by 22% in the heat sink 100, but the same mass-flow enters the heat sink 100 through the front. The temperature of the entering air is lower by 7.4°C compared to the reference heat sink.

FIG. 6 shows in (3) that the heat sink 100 air flows from the space 200 into the heat sink 100 right near the primary fins 102 (indicated by arrows). Thus, a better contact of fresh air with the heat transfer surface is provided. For instance, compared to the reference heat sink, the heat transfer surface of the primary fins 102 is the same, but the heat sink 100 provides better cooling, particularly higher by 14W or 12%.

In summary, embodiments of the present invention provide the heat sink 100 and the heat sink blade 500 with multiple benefits. In particular, the heat sink design of the heat sink 100 gives higher thermal benefit with reasonable increase of the number of primary fins 102 for the same width of the heat sink 100, since more gaps/spaces 201/200 for entering air appear. Further, the proposed heat sink design can be used for any device that is to be cooled by natural convection and is installed outdoors or in relatively large closed spaces or rooms. The heat sink 100 may also be useful for installation inside boxes with opened bottom and top.

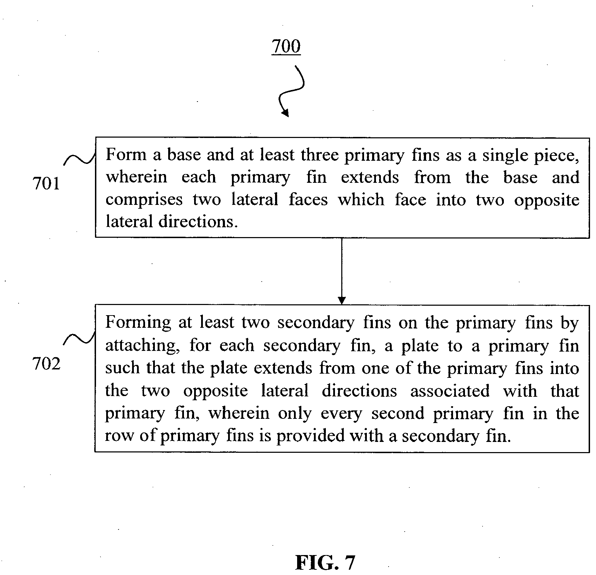

FIG. 7 shows a method 700 according to an embodiment not covered by the claimed invention, since the essential feature that the secondary fins are obtained by stamping out an integral metal plate, according to the appended independent method claim is not present in this figure. . In particular, a method 700 for fabricating a heat sink 100 as shown and described above. The method 700 comprises a step 701 of forming a base 101 and at least three primary fins 102 as a single piece, wherein each primary fin 102 extends from the base 101 and comprises two lateral faces which face into two opposite lateral directions. Further, the method 700 comprises a step 702 of forming at least two secondary fins 103 on the primary fins 102 by attaching, for each secondary fin 103, a plate to a primary fin 102 such that the plate extends from one of the primary fins 102 into the two opposite lateral directions associated with that primary fin 102, wherein only every second primary fin 102 in the row of primary fins 102 is provided with a secondary fin 103.

The present invention has been described in conjunction with various embodiments as examples as well as implementations. However, other variations can be understood and effected by those persons skilled in the art and practicing the claimed invention, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A heat sink (100) for a remote radio unit, the heat sink (100) comprising:
a base (101),
at least three primary fins (102) arranged in a row, wherein each primary fin (102) extends from the base (101) and comprises two lateral faces which face into two opposite lateral directions, and
at least two secondary fins (103) formed on the primary fins (102), wherein each secondary fin (103) extends from one of the primary fins (102) into the two opposite lateral directions associated with that primary fin (102),
wherein only every second primary fin (102) in the row of primary fins (102) is provided with a secondary fin (103)
wherein the heat sink (100) comprises an integral metal plate (300) which comprises the plurality of the secondary fins (103).

2. The heat sink (100) according to claim 1, wherein:
each primary fin (102) comprises a plate which is arranged on the base (101) and oriented perpendicularly to the base (101), and
each secondary fin (103) comprises a plate arranged on a primary fin (102) and oriented parallel to the base (101).

3. The heat sink (100) according to any one of the claims 1 to 2, wherein:
a space (200) is formed between neighboring secondary fins (103) provided on primary fins (102) in the row of primary fins (102), and
a primary fin (102) is arranged, particularly centered, in the space (200).

4. The heat sink (100) according to any one of the claims 1 to 3, wherein:
a gap (201) is formed between an edge of a secondary fin (103) provided on a primary fin (101) and a top edge of a neighboring primary fin (102) in the row of primary fins (102).

5. The heat sink (100) according to at least claim 3, wherein:
the space (200) between two neighboring secondary fins (103) is formed by an opening (301) in the integral metal plate (300).

6. The heat sink (100) according to claim 5, wherein:
the opening (301) in the integral metal plate (300) is elongated and extends over and along the top edge of a primary fin (102).

7. The heat sink (100) according to claim 6, wherein:
the integral metal plate (300) comprises one or more further elongated openings (302) extending perpendicularly to the elongated opening (301) that extends over and along the top edge of the primary fin (102).

8. The heat sink (100) according to one of claims 1 to 7, wherein:
the integral metal plate (300) has been formed by stamping a metal sheet.

9. The heat sink (100) according to one of claims 1 to 8, wherein:
the integral metal plate (300) comprises a plurality of sections (300a, 300b, 300c), each section forming a plurality of secondary fins (103) arranged in a row.

10. A heat sink blade (500) comprising at least two stacked heat sinks (501), wherein:
at least one of the heat sinks (501) is a heat sink (100) according to one of the claims 1 to 9.

11. A method (700) for fabricating a heat sink (100) according to any of claims 1 to 9, the method (700) comprising:
forming (701) a base (101) and at least three primary fins (102) as a single piece, wherein each primary fin (102) extends from the base (101) and comprises two lateral faces which face into two opposite lateral directions, and
forming (702) at least two secondary fins (103) on the primary fins (102) by attaching, for each secondary fin (103), a plate to a primary fin (102) such that the plate extends from one of the primary fins (102) into the two opposite lateral directions associated with that primary fin (102),
wherein only every second primary fin (102) in the row of primary fins (102) is provided with a secondary fin (103);
the method further comprising:
providing a metal sheet,
stamping the metal sheet to produce an integral metal plate (300) with at least one elongated opening (301), and
attaching the integral metal plate (300) to the primary fins (102), wherein each elongated opening (301) extends over and along the top edge of a primary fin (102).

## Patentansprüche

1. Kühlkörper (100) für eine entfernte Funkeinheit, wobei der Kühlkörper (100) Folgendes umfasst:
eine Basis (101),
mindestens drei in einer Reihe angeordnete Primärrippen (102), wobei sich jede Primärrippe (102) von der Basis (101) aus erstreckt und zwei Seitenflächen umfasst, die in zwei entgegengesetzte Seitenrichtungen gerichtet sind, und
mindestens zwei Sekundärrippen (103), die auf den Primärrippen (102) gebildet sind, wobei sich jede Sekundärrippe (103) von einer der Primärrippen (102) in die zwei entgegengesetzten Seitenrichtungen erstreckt, die dieser Primärrippe (102) zugeordnet sind,
wobei nur jede zweite Primärrippe (102) in der Reihe der Primärrippen (102) mit einer Sekundärrippe (103) versehen ist, wobei der Kühlkörper (100) eine integrale Metallplatte (300) umfasst, die die Vielzahl von Sekundärrippen (103) umfasst.

2. Kühlkörper (100) nach Anspruch 1, wobei:
jede Primärrippe (102) eine Platte umfasst, die auf der Basis (101) angeordnet und senkrecht zur Basis (101) ausgerichtet ist, und
jede Sekundärrippe (103) eine Platte umfasst, die auf einer Primärrippe (102) angeordnet und parallel zur Basis (101) ausgerichtet ist.

3. Kühlkörper (100) nach einem der Ansprüche 1 bis 2, wobei:
ein Raum (200) zwischen benachbarten Sekundärrippen (103) gebildet wird, die auf Primärrippen (102) in der Reihe von Primärrippen (102) bereitgestellt sind, und
eine Primärrippe (102) in dem Raum (200) insbesondere mittig angeordnet ist.

4. Kühlkörper (100) nach einem der Ansprüche 1 bis 3, wobei:
zwischen einer Kante einer Sekundärrippe (103), die auf einer Primärrippe (101) bereitgestellt ist, und einer Oberkante einer benachbarten Primärrippe (102) in der Reihe der Primärrippen (102) ein Spalt (201) gebildet wird.

5. Kühlkörper (100) nach mindestens Anspruch 3, wobei:
der Raum (200) zwischen zwei benachbarten Sekundärrippen (103) durch eine Öffnung (301) in der integralen Metallplatte (300) gebildet wird.

6. Kühlkörper (100) nach Anspruch 5, wobei:
die Öffnung (301) in der integralen Metallplatte (300) länglich ist und sich über und entlang der Oberkante einer Primärrippe (102) erstreckt.

7. Kühlkörper (100) nach Anspruch 6, wobei:
die integrale Metallplatte (300) eine oder mehrere weitere längliche Öffnungen (302) umfasst, die sich senkrecht zur länglichen Öffnung (301) erstrecken, die sich über und entlang der Oberkante der Primärrippe (102) erstreckt.

8. Kühlkörper (100) nach einem der Ansprüche 1 bis 7, wobei:
die integrale Metallplatte (300) durch Stanzen eines Metallblechs gebildet wurde.

9. Kühlkörper (100) nach einem der Ansprüche 1 bis 8, wobei:
die integrale Metallplatte (300) eine Vielzahl von Abschnitten (300a, 300b, 300c) umfasst, wobei jeder Abschnitt eine Vielzahl von Sekundärrippen (103) bildet, die in einer Reihe angeordnet ist.

10. Kühlkörper-Blatt (500), das mindestens zwei gestapelte Kühlkörper (501) umfasst, wobei:
mindestens einer der Kühlkörper (501) ein Kühlkörper (100) nach einem der Ansprüche 1 bis 9 ist.

11. Verfahren (700) zur Herstellung eines Kühlkörpers (100) nach einem der Ansprüche 1 bis 9, wobei das Verfahren (700) Folgendes umfasst:
Bilden (701) einer Basis (101) und von mindestens drei Primärrippen (102) in einem Stück, wobei sich jede Primärrippe (102) von der Basis (101) erstreckt und zwei Seitenflächen umfasst, die in zwei entgegengesetzte Seitenrichtungen gerichtet sind, und
Bilden (702) von mindestens zwei Sekundärrippen (103) auf den Primärrippen (102), indem für jede Sekundärrippe (103) eine Platte an einer Primärrippe (102) befestigt wird, derart, dass sich die Platte von einer der Primärrippen (102) in die zwei entgegengesetzten Seitenrichtungen, die dieser Primärrippe (102) zugeordnet sind, erstreckt,
wobei nur jede zweite Primärrippe (102) in der Reihe der Primärrippen (102) mit einer Sekundärrippe (103) versehen ist, wobei das Verfahren ferner Folgendes umfasst:
Bereitstellen eines Metallblechs,
Stanzen des Metallblechs, um eine integrale Metallplatte (300) mit mindestens einer länglichen Öffnung (301) herzustellen, und
Anbringen der integralen Metallplatte (300) an den Primärrippen (102), wobei sich jede längliche Öffnung (301) über und entlang der Oberkante einer Primärrippe (102) erstreckt.

## Revendications

1. Dissipateur thermique (100) pour une unité radio distante, le dissipateur thermique (100) comprenant :
une base (101),
au moins trois ailettes primaires (102) agencées en rangée, dans lequel chaque ailette primaire (102) s'étend à partir de la base (101) et comprend deux faces latérales qui font face dans deux directions latérales opposées, et
au moins deux ailettes secondaires (103) formées sur les ailettes primaires (102), dans lequel chaque ailette secondaire (103) s'étend à partir de l'une des ailettes primaires (102) dans les deux directions latérales opposées associées à cette ailette primaire (102),
dans lequel seule une ailette primaire sur deux (102) dans la rangée d'ailettes primaires (102) est dotée d'une ailette secondaire (103).
dans lequel le dissipateur thermique (100) comprend une plaque métallique intégrée (300) qui comprend la pluralité d'ailettes secondaires (103).

2. Dissipateur thermique (100) selon la revendication 1, dans lequel :
chaque ailette primaire (102) comprend une plaque qui est agencée sur la base (101) et orientée perpendiculairement à la base (101), et
chaque ailette secondaire (103) comprend une plaque agencée sur une ailette primaire (102) et orientée parallèlement à la base (101).

3. Dissipateur thermique (100) selon l'une quelconque des revendications 1 à 2, dans lequel :
un espace (200) est formé entre des ailettes secondaires voisines (103) prévues sur des ailettes primaires (102) dans la rangée d'ailettes primaires (102), et
une ailette primaire (102) est agencée, particulièrement centrée, dans l'espace (200).

4. Dissipateur thermique (100) selon l'une quelconque des revendications 1 à 3, dans lequel :
un interstice (201) est formé entre un bord d'une ailette secondaire (103) prévue sur une ailette primaire (101) et un bord supérieur d'une ailette primaire voisine (102) dans la rangée d'ailettes primaires (102).

5. Dissipateur thermique (100) selon au moins la revendication 3, dans lequel :
l'espace (200) entre deux ailettes secondaires voisines (103) est formé par une ouverture (301) dans la plaque métallique intégrée (300).

6. Dissipateur thermique (100) selon la revendication 5, dans lequel :
l'ouverture (301) dans la plaque métallique intégrée (300) est allongée et s'étend sur et le long du bord supérieur d'une ailette primaire (102).

7. Dissipateur thermique (100) selon la revendication 6, dans lequel :
la plaque métallique intégrée (300) comprend une ou plusieurs autres ouvertures allongées (302) s'étendant perpendiculairement à l'ouverture allongée (301) qui s'étend sur et le long du bord supérieur de l'ailette primaire (102).

8. Dissipateur thermique (100) selon l'une des revendications 1 à 7, dans lequel :
la plaque métallique intégrée (300) a été formée par estampage d'une tôle.

9. Dissipateur thermique (100) selon l'une des revendications 1 à 8, dans lequel
la plaque métallique intégrée (300) comprend une pluralité de sections (300a, 300b, 300c), chaque section formant une pluralité d'ailettes secondaires (103) agencées en rangée.

10. Lame de dissipateur thermique (500) comprenant au moins deux dissipateurs thermiques empilés (501), dans laquelle :
au moins un des dissipateurs thermiques (501) est un dissipateur thermique (100) selon l'une des revendications 1 à 9.

11. Procédé (700) pour fabriquer un dissipateur thermique (100) selon l'une quelconque des revendications 1 à 9, le procédé (700) comprenant :
la formation (701) d'une base (101) et d'au moins trois ailettes primaires (102) en une seule pièce, dans lequel chaque ailette primaire (102) s'étend à partir de la base (101) et comprend deux faces latérales qui font face dans deux directions latérales opposées, et
la formation (702) d'au moins deux ailettes secondaires (103) sur les ailettes primaires (102) en fixant, pour chaque ailette secondaire (103), une plaque à une ailette primaire (102) de sorte que la plaque s'étend à partir de l'une des ailettes primaires (102) dans les deux directions latérales opposées associées à cette ailette primaire (102),
dans lequel seule une ailette primaire sur deux (102) dans la rangée d'ailettes primaires (102) est dotée d'une ailette secondaire (103) ;
le procédé comprenant également :
la fourniture d'une tôle,
l'estampage de la tôle pour produire une plaque métallique intégrée (300) avec au moins une ouverture allongée (301), et la fixation de la plaque métallique intégrée (300) aux ailettes primaires (102), dans lequel chaque ouverture allongée (301) s'étend sur et le long du bord supérieur d'une ailette primaire (102).
